# EUROPEAN PATENT APPLICATION

(11) **EP 2 413 377 A1**
(43) Date of publication of application: **01.02.2012**
(21) Application number: 10755698.7
(22) Date of filing: 26.03.2010
(51) Int. Cl.: H01L 31/042, B32B 27/32

(54) **PROTECTIVE SHEET FOR SOLAR CELL MODULE AND SOLAR CELL MODULE COMPRISING THE SAME**

(30) Priority: 26.03.2009 JP 2009075323
(71) Applicant: LINTEC Corporation, Tokyo 173-0001 (JP)
(72) Inventor: TAKANASHI, Yasunari, Tokyo 173-0001 (JP); UTAGAWA, Tetsuyuki, Tokyo 173-0001 (JP); KATO, Kiichiro, Tokyo 173-0001 (JP)
(74) Representative: Jansen, Cornelis Marinus
(86) International application number: PCT/JP2010/002158
(87) International publication number: WO 2010/109896

(57) **Abstract**

The protective sheet for solar cell module of the present invention includes a substrate film and a heat bondable layer laminated on one side of the substrate film, wherein the heat bondable layer is formed from a resin material containing an olefin-based polymer that includes a (meth)acrylate unit having a glycidyl group, and serves as an adhesive layer to be used for bonding with a encapsulant that constitutes the solar cell module.

## Description

### TECHNICAL FIELD

The present invention relates to a protective sheet for solar cell module to be used either as a front surface protective sheet or a back surface protective sheet in a solar cell module, and a solar cell module that includes the same.
Priority is claimed on Japanese Patent Application No. 2009-75323, filed March 26, 2009, the content of which is incorporated herein by reference.

### BACKGROUND ART

In response to concerns over the environmental issues, such as air pollution and global warming, solar cell modules that convert the energy of sunlight into the electrical energy have been attracting attention as a clean energy source capable of generating power without causing carbon dioxide emissions.
In general, a solar cell module is mainly constituted of a solar cell that performs photoelectric conversion, a encapsulant (sealing layer) formed of an electrical insulator that encapsulates the solar cell, a front surface protective sheet (front sheet) laminated on the front surface of the encapsulant, and a back surface protective sheet (back sheet) laminated on the back surface of the encapsulant. These solar cell modules are required to have certain levels of moisture resistance and weather resistance to be used outdoors as well as indoors for a prolonged period of time.

This solar cell module is mainly constituted of a solar cell composed of crystalline silicon, amorphous silicon or the like, a encapsulant (filling layer) formed of an electrical insulator that encapsulates the solar cell, a front surface protective sheet (front sheet) laminated on the front surface of the encapsulant, and a back surface protective sheet (back sheet) laminated on the back surface of the encapsulant.
As back surface protective sheets as described above, a back surface protective sheet in which a fluorine-based plastic film is provided on one or both sides of a layer made of metal or the like for preventing the permeation of water vapor has been disclosed (for example, refer to Patent Document 1). This back surface protective sheet is fused with a encapsulant composed of an ethylene-vinyl acetate (EVA) copolymer by a hot press method.

### [Prior Art Document]

### [Patent Document]

[Patent Document 1] Japanese Unexamined Patent Application, First Publication No. Hei 6-177412

### SUMMARY OF THE INVENTION

### PROBLEMS TO BE SOLVED BY THE INVENTION

However, when a conventional back surface protective sheet is used in a solar cell module, the back surface protective sheet is detached from a encapsulant, due to low adhesion to the encapsulant, thereby incorporating water vapor within the encapsulant.

The present invention has been developed in light of the circumstances described above, and has an object of providing a protective sheet for solar cell module which exhibits, when used in a solar cell module, excellent adhesion to a encapsulant in the solar cell module, and a solar cell module that uses the protective sheet.

### MEANS FOR SOLVING THE PROBLEMS

A protective sheet for solar cell module according to the present invention is a protective sheet for solar cell module including a substrate film and a heat bondable layer laminated on at least one side of the substrate film, wherein the heat bondable layer is formed from a resin material containing an olefin-based polymer that includes a (meth)acrylate unit having a glycidyl group, and serves as an adhesive layer to be used for bonding with a encapsulant that constitutes the solar cell module.

A solar cell module of the present invention is a solar cell module including a solar cell, a encapsulant for encapsulating the solar cell, and a protective sheet laminated on the encapsulant, wherein the protective sheet is constituted of the above-mentioned protective sheet for solar cell module, and the protective sheet is laminated on the encapsulant via the heat bondable layer.

The encapsulant is preferably composed of a polyolefin-based resin.
With respect to the aforementioned olefin-based polymer that includes a (meth)acrylate unit having a glycidyl group, the content of the (meth)acrylate unit having a glycidyl group is preferably within a range from 6 to 20% by weight.
It is preferable that the aforementioned olefin-based polymer that includes a (meth)acrylate unit having a glycidyl group further include an alkyl (meth)acrylate unit.
With respect to the aforementioned olefin-based polymer that includes a (meth)acrylate unit having a glycidyl group, the content of the alkyl (meth)acrylate unit is preferably within a range from 5 to 40% by weight.
It is preferable that the aforementioned olefin-based polymer that includes a (meth)acrylate unit having a glycidyl group be a ternary copolymer containing an ethylene unit, a (meth)acrylate unit having a glycidyl group and an alkyl (meth)acrylate unit.
It is preferable that a deposition layer composed of an inorganic oxide be provided on at least one side of the substrate film.
The solar cell module of the present invention is preferably a solar cell module in which the above-mentioned protective sheet for solar cell module is laminated on both sides of the encapsulant.
In the solar cell module of the present invention, a flexible substrate is preferably used in the solar cell.

### EFFECTS OF THE INVENTION

According to the protective sheet for solar cell module of the present invention, because it is a protective sheet for solar cell module including a substrate film and a heat bondable layer laminated on at least one side of the substrate film, wherein the heat bondable layer is formed from a resin material containing an olefin-based polymer that includes a (meth)acrylate unit having a glycidyl group, and serves as the adhesive layer to be used for bonding with a encapsulant that constitutes the solar cell module, the heat bondable layer exhibits excellent adhesion to the substrate film even when no corona treatment is conducted on the substrate film. Moreover, since this heat bondable layer also exhibits excellent adhesion to the encapsulant of the solar cell module, the protective sheet for solar cell module according to the present invention hardly detach from the solar cell module.

### BRIEF DESCRIPTION OF THE DRAWINGS

FIG. 1 is a schematic cross sectional view showing a first embodiment of a protective sheet for solar cell module according to the present invention.
FIG. 2 is a schematic cross sectional view showing a second embodiment of a protective sheet for solar cell module according to the present invention.
FIG. 3 is a schematic cross sectional view showing a third embodiment of a protective sheet for solar cell module according to the present invention.
FIG. 4 is a schematic cross sectional view showing a fourth embodiment of a protective sheet for solar cell module according to the present invention.
FIG. 5 is a schematic cross sectional view showing a fifth embodiment of a protective sheet for solar cell module according to the present invention.
FIG. 6 is a schematic cross sectional view showing an embodiment of a solar cell module according to the present invention.

### DESCRIPTION OF THE EMBODIMENTS

Embodiments of a protective sheet for solar cell module and a solar cell module that uses the protective sheet according to the present invention will be described.
It should be noted that these embodiments are provided for the sake of detailed description in order to facilitate better understanding of the intent of the present invention, and do not limit the scope of the present invention in any way unless otherwise stated.

### (1) First embodiment

### Protective sheet for solar cell module

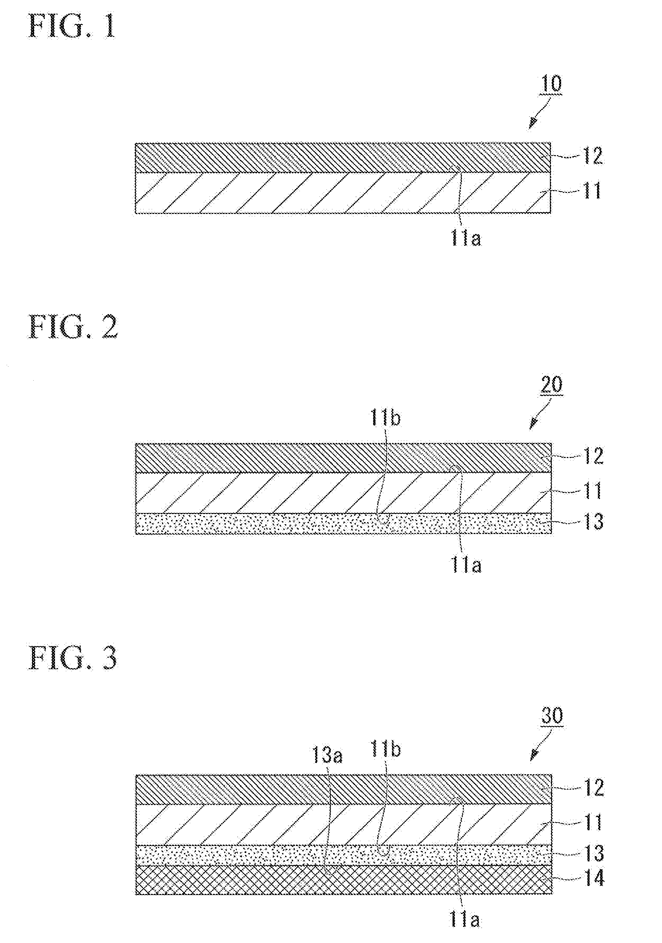

FIG. 1 is a schematic cross sectional view showing a first embodiment of a protective sheet for solar cell module according to the present invention.
A protective sheet for solar cell module 10 of the present embodiment is mainly constituted of a substrate film 11 and a heat bondable layer 12 laminated on one side 11a of the substrate film 11.
This protective sheet for solar cell module 10 is employed as a front sheet or a back sheet in the solar cell module.

As the substrate film 11, a resin film or the like is used, provided that it is electrically insulating and the heat bondable layer 12 can be laminated thereon.

As a resin film used as the substrate film 11, those that are generally used as resin films in the protective sheets for solar cell module are selected. As such resin films, for example, resin films or sheets composed of resins including olefin-based resins such as polyethylene and polypropylene, ester-based resins such as polyethylene terephthalate (PET) and polyethylene naphthalate, amide-based resins such as nylon (product name), carbonate-based resins, styrene-based resins, vinyl alcohol-based resins such as polyvinyl alcohol and ethylene-vinyl acetate copolymer (EVA), acrylonitrile-based resins, vinyl chloride-based resins, vinyl acetal-based resins, vinyl butyral-based resins, and fluorine-based resins, may be used. Of these resin films, films composed of polyesters are preferred, and more specifically, PET films are suitable.

The thickness of the substrate film 11 is appropriately set, based on the level of electrical insulation required for the solar cell module. For example, when the substrate film 11 is a resin film, the thickness thereof is preferably within a range from 10 µm to 300 µm. More specifically, when the substrate film 11 is a PET film, from the viewpoints of weight reduction and electrical insulation, the thickness thereof is preferably within a range from 10 µm to 300 µm, more preferably within a range from 20 µm to 250 µm, and most preferably within a range from 30 µm to 200 µm.

The heat bondable layer 12 is formed from a resin material containing an olefin-based polymer that includes a (meth)acrylate unit having a glycidyl group, and serves as the adhesive layer to be used for bonding with a encapsulant that constitutes the solar cell module.

By laminating the heat bondable layer 12 on one side 11a of the substrate film 11 as an outermost layer of the protective sheet for solar cell module 10, the protective sheet for solar cell module 10 can be bonded to the outer surface of the encapsulant that constitutes the solar cell module. The heat bondable layer 12 can be bonded to the encapsulant of the solar cell module through a hot press process within a temperature range from 50 to 200°C, and strongly adheres to the encapsulant.

As the olefin-based polymer including a (meth)acrylate unit having a glycidyl group that constitutes the heat bondable layer 12, a binary copolymer containing an ethylene unit and a (meth)acrylate unit having a glycidyl group, a ternary copolymer containing an ethylene unit, a (meth)acrylate unit having a glycidyl group and an alkyl (meth)acrylate unit, or the like is used. Of these, in view of adhesiveness, a ternary copolymer containing an ethylene unit, a (meth)acrylate unit having a glycidyl group and an alkyl (meth)acrylate unit is preferred.

Further, in the olefin-based polymer that includes a (meth)acrylate unit having a glycidyl group, the content of the (meth)acrylate unit having a glycidyl group is preferably within a range from 6 to 20% by weight, and more preferably within a range from 7 to 15% by weight.
Furthermore, when the olefin-based polymer that includes a (meth)acrylate unit having a glycidyl group also includes an alkyl (meth)acrylate unit, the content of the alkyl (meth)acrylate unit is preferably within a range from 5 to 40% by weight, and more preferably within a range from 10 to 30% by weight.
If the contents of the (meth)acrylate unit having a glycidyl group and the alkyl (meth)acrylate unit, in the olefin-based polymer that includes a (meth)acrylate unit having a glycidyl group, are within the above-mentioned ranges, the heat bondable layer 12 exhibits excellent adhesion when subjected to a hot press process and can be strongly adhered to the encapsulant.

The resin material forming the heat bondable layer 12 may include other resins, curing agents, catalysts or the like, in addition to the aforementioned olefin-based polymer that includes a (meth)acrylate unit having a glycidyl group.
As the other resins described above, resins exhibiting superior compatibility with the olefin-based polymer that includes a (meth)acrylate unit having a glycidyl group, or resins exhibiting excellent adhesion to the substrate film 11 as well as to the encapsulant of the solar cell module are selected. Examples thereof include polyethylene resins such as low-density polyethylenes (LDPE, having a density equal to or more than 0.910 g/cm³ and less than 0.930 g/cm³), medium-density polyethylenes (MDPE, having a density equal to or more than 0.930 g/cm³ and less than 0.942 g/cm³) and high-density polyethylenes (HDPE, having a density equal to or more than 0.942 g/cm³); polypropylene resins (PP); and polyolefin-based resins such as olefin-based elastomers (TPO), cycloolefin resins, ethylene-vinyl acetate copolymers (EVA), ethylene-vinyl acetate-maleic anhydride copolymers, ethylene-(meth)acrylic acid copolymers, and ethylene-(meth)acrylate-maleic anhydride copolymers.
The content of the other resins in the heat bondable layer 12 is about 0 to about 20% by weight.

The thickness of the heat bondable layer 12 is appropriately adjusted in accordance with the substrate film 11 and the encapsulant of the solar cell module. The thickness of the heat bondable layer 12 is, for example, preferably within a range from 1 µm to 200 µm, and from the viewpoints of weight reduction, electrical insulation and the like, more preferably within a range from 10 µm to 200 µm, still more preferably within a range from 50 µm to 150 µm, and most preferably within a range from 80 µm to 120 µm.

This protective sheet for solar cell module 10 has the substrate film 11 and the heat bondable layer 12 laminated on one side 11a of the substrate film 11, and the heat bondable layer 12 is formed from a resin material containing an olefin-based polymer that includes a (meth)acrylate unit having a glycidyl group, so that the heat bondable layer 12 exhibits excellent adhesion to the substrate film 11 even when no corona treatment is conducted on the one side 11a of the substrate film 11. Furthermore, since this heat bondable layer 12 also exhibits excellent adhesion to the encapsulant of the solar cell module, the protective sheet for solar cell module 10 hardly detach from the solar cell module.

It should be noted that although the protective sheet for solar cell module 10 in which the heat bondable layer 12 is laminated on one side 11a of the substrate film 11 has been described as an example in the present embodiment, the protective sheet for solar cell module according to the present invention is not limited thereto. With respect to the protective sheet for solar cell module according to the present invention, a heat bondable layer may also be laminated on the other side (the side opposite to "one side") of the substrate film.

### (Method of producing protective sheet for solar cell module)

Next, a method of producing the protective sheet for solar cell module 10 will be described by referring to FIG. 1.
In order to produce the protective sheet for solar cell module 10, through an extrusion molding using a T-die extruder or T-die film forming machine, a resin material for forming a heat bondable layer is melted and kneaded, and the melted resin material is then extruded and laminated on one side 11a of the substrate film 11 while moving the substrate film 11 at a constant speed, thereby forming the heat bondable layer 12 composed of a resin material on one side 11a of the substrate film 11 to obtain the protective sheet for solar cell module 10.

The temperature for melting the resin material that forms the heat bondable layer 12 is set to a degree so that the substrate film 11 does not shrink by the temperature (heat) of the melted resin material, is preferably within a range from 80 to 350°C, and is more preferably within a range from 150 to 300°C.

Further, the discharged amount of the resin material for forming the heat bondable layer 12 from the T-die extruder (or T-die film forming machine) is appropriately adjusted in accordance with the intended thickness of the heat bondable layer 12 and the traveling speed (moving rate) of the substrate film 11.

The substrate film 11 is moved (transported) in the longitudinal direction, for example, by a roll-to-roll system at a constant speed, and the moving rate thereof is appropriately adjusted in accordance with the discharged amount of the resin material for forming the heat bondable layer 12 from the T-die extruder (or T-die film forming machine).

According to the extrusion molding process as described above, the heat bondable layer 12 can be bonded to the substrate film 11 only by extruding the melted resin material for forming the heat bondable layer 12 from the T-die extruder (or T-die film forming machine) and laminating on one side 11a of the substrate film 11.

### (2) Second embodiment

FIG. 2 is a schematic cross sectional view showing a second embodiment of a protective sheet for solar cell module according to the present invention.
In FIG. 2, the same components as those in the protective sheet for solar cell module 10 shown in FIG. 1 will be given the same reference numerals, and the explanations thereof will be omitted here.
A protective sheet for solar cell module 20 of the present embodiment is employed, like the protective sheet of the first embodiment, as a front sheet or a back sheet in the solar cell module.

In the protective sheet for solar cell module 20, a deposition layer 13 is further provided in addition to the structure of the protective sheet for solar cell module 10 in the first embodiment.
In the present embodiment, the substrate film 11 and the heat bondable layer 12 have the same configurations as those in the first embodiment.

The deposition layer 13 is laminated, on the substrate film 11, on a side (hereafter, referred to as "the other side") 11b which is opposite to the side where the heat bondable layer 12 is provided.

The deposition layer 13 is constituted of inorganic materials such as metals and their oxides, nitrides, oxynitrides and silicides, and they are not particularly limited as long as the layer is formed through the deposition on the substrate film 11.
As the deposition method for forming the deposition layer 13, for example, chemical vapor deposition methods such as plasma enhanced chemical vapor deposition methods, thermal chemical vapor deposition methods and photochemical vapor deposition methods, or physical vapor deposition methods such as vacuum deposition methods, sputtering methods and ion plating methods are used. Of these methods, sputtering methods are preferred when operability or controllability of the layer thickness is taken into consideration.

This deposition layer 13 serves as a moisture-proof layer having water vapor barrier properties. Further, the weather resistance of the solar cell module can be improved by adopting the deposition layer 13 in the solar cell module.

As a metal, for example, metals such as silicon (Si), aluminum (A1), magnesium (Mg), calcium (Ca), potassium (K), tin (Sn), sodium (Na), boron (B), titanium (Ti), lead (Pb), zirconium (Zr) and yttrium (Y) are used.
Examples of oxides, nitrides and oxynitrides of these metals include silicon oxide, aluminum oxide, tin oxide, silicon nitride, silicon oxynitride and aluminum oxynitride.

The deposition layer 13 may be composed of one type of inorganic material, or may be composed of several types of inorganic materials.
In those cases where the deposition layer 13 is composed of plural types of inorganic materials, the deposition layer may have a lamination structure in which layers composed of each inorganic material are sequentially deposited, or the deposition layer may be a layer in which several types of inorganic materials are deposited at the same time.

The thickness of the deposition layer 13 is appropriately set in consideration of the water vapor barrier properties, and is changed depending on the type of inorganic material used, the deposition density, or the like. The thickness of the deposition layer 13 is preferably within a range from 5 nm to 200 nm, and more preferably within a range from 10 nm to 100 nm.

According to the protective sheet for solar cell module 20, by providing the deposition layer 13 to the substrate film 11 in addition to the protective sheet for solar cell module 10 of the first embodiment, the moisture-proof properties and the weather resistance can be improved, in addition to the effects achieved by the protective sheet for solar cell module 10.

Further, although the protective sheet for solar cell module 20 in which the deposition layer 13 is provided on the other side 11b of the substrate film 11 has been described as an example in the present embodiment, the protective sheet for solar cell module according to the present invention is not limited thereto. With respect to the protective sheet for solar cell module according to the present invention, a deposition layer may be provided on both sides (i.e., on one side as well as on the other side) of the substrate film.

### (3) Third embodiment

FIG. 3 is a schematic cross sectional view showing a third embodiment of a protective sheet for solar cell module according to the present invention.
In FIG. 3, the same components as those in the protective sheet for solar cell module 10 shown in FIG. 1 and those in the protective sheet for solar cell module 20 shown in FIG. 2 will be given the same reference numerals, and the explanations thereof will be omitted here.
A protective sheet for solar cell module 30 of the present embodiment is employed, like the protective sheets of the first and second embodiments, as a front sheet or a back sheet in the solar cell module.

In the protective sheet for solar cell module 30, a fluororesin layer 14 is further provided in addition to the structure of the protective sheet for solar cell module 20 in the second embodiment.
In the present embodiment, the substrate film 11 and the heat bondable layer 12 have the same configurations as those in the first embodiment, and the deposition layer 13 has the same configurations as those in the second embodiment.

The fluororesin layer 14 is laminated, on the deposition layer 13, on a side (hereafter, referred to as "one side") 13a which is opposite to the side where the substrate film 11 comes into contact. The fluororesin layer 14 is provided so as to become a cured layer.

The thickness of the fluororesin layer 14 is set by taking the weather resistance, chemical resistance, weight reduction or the like into consideration, and is preferably within a range from 5 µm to 50 µm, more preferably within a range from 10 µm to 30 µm.

The fluororesin layer 14 is not particularly limited as long as it is a layer containing fluorine. Examples of those for forming the layer containing fluorine include a sheet including a fluorine-containing resin, and a coating film prepared by applying a coating material that includes a fluorine-containing resin. Of these, a coating film prepared by applying a coating material including a fluorine-containing resin is preferred from the viewpoint of further reducing the thickness of the fluororesin layer 14, in order to reduce the weight of the protective sheet for solar cell module 30.

In those cases where the fluororesin layer 14 is a sheet including a fluorine-containing resin, the fluororesin layer 14 is laminated on the deposition layer 13 via an adhesive layer. The adhesive layer is constituted of an adhesive that exhibits adhesion to the deposition layer 13.
As the adhesive that constitutes this adhesive layer, polyacrylic adhesives, polyurethane-based adhesives, epoxy-based adhesives, polyester-based adhesives, polyester polyurethane-based adhesives and the like are used. These adhesives may be used individually, or two or more types thereof may be used in combination.

On the other hand, in those cases where the fluororesin layer 14 is a coating film prepared by applying a coating material that includes a fluorine-containing resin, the fluororesin layer 14 is usually laminated on the deposition layer 13, without providing an adhesive layer, by directly applying the coating material that includes a fluorine-containing resin onto the deposition layer 13.

As a sheet including a fluorine-containing resin, for example, those resins that are mainly composed of polyvinyl fluoride (PVF), ethylene chlorotrifluoroethylene (ECTFE) or ethylene tetrafluoroethylene (ETFE) and processed into a sheet form are used.
As a resin mainly composed of PVF, for example, the "TEDLAR" series of products (manufactured by E.I.du Pont de Nemours and Company) are used.
As a resin mainly composed of ECTFE, for example, the "HALAR" series of products (manufactured by Solvay Solexis Inc.) are used.
As a resin mainly composed of ETFE, for example, the "FLUON" series of products (manufactured by Asahi Glass Co., Ltd.) are used.

There are no particular limitations on the coating materials that include a fluorine-containing resin, provided that they are prepared by being dissolved in a solvent or dispersed in water, and are also coatable.

As a fluorine-containing resin included in the coating material, a fluorine-containing resin which is soluble in a solvent of coating material (either an organic solvent or water) and is also crosslinkable may be used, although the resin is not particularly limited as long as it is a resin containing fluorine and does not impair the effects of the present invention.
As a fluorine-containing resin included in the coating material, it is preferable to use a fluoroolefin resin having a curable functional group. As the fluoroolefin resin, copolymers composed of tetrafluoroethylene (TFE), isobutylene, vinylidene fluoride (VdF), hydroxybutyl vinyl ether and other monomers, and copolymers composed of TFE, VdF, hydroxybutyl vinyl ether and other monomers are used.

Specific examples of the fluoroolefin resin include polymers mainly composed of chlorotrifluoroethylene (CTFE) such as the "LUMIFLON" series of products (manufactured by Asahi Glass Co., Ltd.), the "CEFRAL COAT" series of products (manufactured by Central Glass Co., Ltd.) and the "FLUONATE" series of products (manufactured by DIC Corporation), polymers mainly composed of tetrafluoroethylene (TFE) such as the "ZEFFLE" series of products (manufactured by Daikin Industries, Ltd.), polymers having a fluoroalkyl group such as the "ZONYL" series of products (manufactured by E.I.du Pont de Nemours and Company) and the "UNIDYNE" series of products (manufactured by Daikin Industries, Ltd.), and polymers mainly composed of fluoroalkyl units.
Of these, from the viewpoints of the weather resistance, the pigment dispersibility and the like, polymers mainly composed of CTFE and polymers mainly composed of TFE are preferred, and the "LUMIFLON" series of products and the "ZEFFLE" series of products are most preferred.

The "LUMIFLON" series of products are noncrystalline resins that contain CTFE and several kinds of specific alkyl vinyl ethers and hydroxyalkyl vinyl ethers as major structural units. As in the case of these "LUMIFLON" series of products, resins including the monomer units of hydroxyalkyl vinyl ethers are preferred because they exhibit excellent levels of solvent solubility, crosslinking reactivity, substrate adhesion, pigment dispersibility, hardness and flexibility.
The "ZEFFLE" series of products are copolymers of TFE and olefinic hydrocarbons soluble in an organic solvent. Of the various possibilities, those containing olefinic hydrocarbons having a highly reactive hydroxyl group are preferred since they exhibit excellent levels of solvent solubility, crosslinking reactivity, substrate adhesion and pigment dispersibility.

As a copolymerizable monomer for forming the fluorine-containing resin included in the coating material, for example, vinyl esters of carboxylic acids such as vinyl acetate, vinyl propionate, butyl butyrate, vinyl isobutyrate, vinyl pivalate, vinyl caproate, vinyl versatate, vinyl laurate, vinyl stearate, vinyl cyclohexylcarboxylate and vinyl benzoate; alkyl vinyl ethers such as methyl vinyl ether, ethyl vinyl ether, butyl vinyl ether and cyclohexyl vinyl ether; and fluorine-containing monomers such as CTFE, vinyl fluoride (VF), VdF and fluorinated vinyl ether are used.

Furthermore, the fluorine-containing resin included in the coating material may be a resin composed of one or more types of monomers, or may be a terpolymer.
As a terpolymer, for example, the "Dyneon THV" series of products (manufactured by 3M Company) which are terpolymers composed of VdF, TFE and hexafluoropropylene are used. Such terpolymers are preferred because they can provide resins with advantageous properties exhibited by the respective monomers. For example, the "Dyneon THV" series of products are preferred because they can be produced at a relatively low temperature and can be bonded to elastomers and hydrocarbon-based plastics, and also exhibit excellent flexibility and optical transparency.

The coating material may contain a cross-linking agent, a catalyst and a solvent, in addition to the aforementioned fluorine-containing resin, and may further contain inorganic compounds such as pigments and fillers if necessary.

The solvents included in the coating material are not particularly limited as long as they do not impair the effects of the present invention, and, for example, solvents containing any one of, or two or more types of organic solvents selected from the group consisting of methyl ethyl ketone (MEK), cyclohexanone, acetone, methyl isobutyl ketone (MIBK), toluene, xylene, methanol, isopropanol, ethanol, heptane, ethyl acetate, isopropyl acetate, n-butyl acetate and n-butyl alcohol are suitably used.
Among such solvents, from the viewpoints of solubility of the components included in the coating material and the low residual level (low boiling point) thereof within the coating film, solvents containing any one of, or two or more types of organic solvents selected from amongst xylene, cyclohexanone, and MEK are particularly desirable.

The pigments and fillers included in the coating material are not particularly limited as long as they do not impair the effects of the present invention, and, for example, titanium dioxide, carbon black, perylene pigments, pigments, dyes, mica, polyamide powers, boron nitride, zinc oxide, aluminum oxide, silica, ultraviolet absorbers, preservatives, desiccants and the like are used. More specifically, as the pigments and fillers, in order to provide durability, "Ti-Pure R105" (product name, manufactured by E. I. du Pont de Nemours and Company) which is rutile-type titanium dioxide treated with silicon oxide, and "CAB-O-SIL TS-720" (product name, manufactured by Cabot Corporation) which is hydrophobic silica prepared by the surface treatment of dimethyl silicone to modify the hydroxyl group in the silica surface are suitably used.

The aforementioned coating film is preferably cured with a cross-linking agent in order to improve the weather resistance and abrasion resistance.
The cross-linking agent is not particularly limited as long as it does not impair the effects of the present invention, and metal chelates, silanes, isocyanates and melamines are suitably used. When assuming that the back sheet 20 is used outdoors for 30 years or longer, aliphatic isocyanates are preferred as cross-linking agents in view of the weather resistance.

Composition of the coating material is not particularly limited as long as it does not impair the effects of the present invention, and the coating material is prepared, for example, by mixing a fluorine-containing resin, a pigment, a cross-linking agent, a solvent and a catalyst.
In terms of the compositional ratio of this composition, the content of the fluorine-containing resin is preferably within a range from 3 to 80% by weight, and more preferably from 25 to 50% by weight, the content of the pigment is preferably within a range from 5 to 60% by weight, and more preferably from 10 to 30% by weight, and the content of the solvent is preferably within a range from 20 to 80% by weight, and more preferably from 25 to 65% by weight, relative to 100% by weight of the coating material as a whole.

As a solvent, for example, a mixed solvent composed of MEK, xylene and cyclohexanone is used.
Further, as a catalyst, for example, dibutyltin dilaurate is used. This catalyst is used for promoting the cross-linking between fluorine-containing resins and isocyanate.

Known methods are employed as a method for applying the coating material onto the deposition layer 13. For example, the coating material may be applied to a desired thickness using a rod coater.
The drying temperature for the coating material applied onto the deposition layer 13 is not restricted, provided that the temperature does not impair the effects of the present invention, and is preferably within a range from 50 to 130°C from the viewpoint of reducing the adverse effects to the deposition layer 13 and the substrate film 11.

According to the protective sheet for solar cell module 30, by providing the fluororesin layer 14 in addition to the protective sheet for solar cell module 20 of the second embodiment, the weather resistance and the chemical resistance can be improved, in addition to the effects achieved by the protective sheet for solar cell module 20. Therefore, in order to improve the weather resistance and chemical resistance of the protective sheet for solar cell module 30, the fluororesin layer 14 is preferably provided on the outer surface of the deposition layer 13 (namely, one side 13a of the deposition layer 13) within the protective sheet for solar cell module 30.

### (4) Fourth embodiment

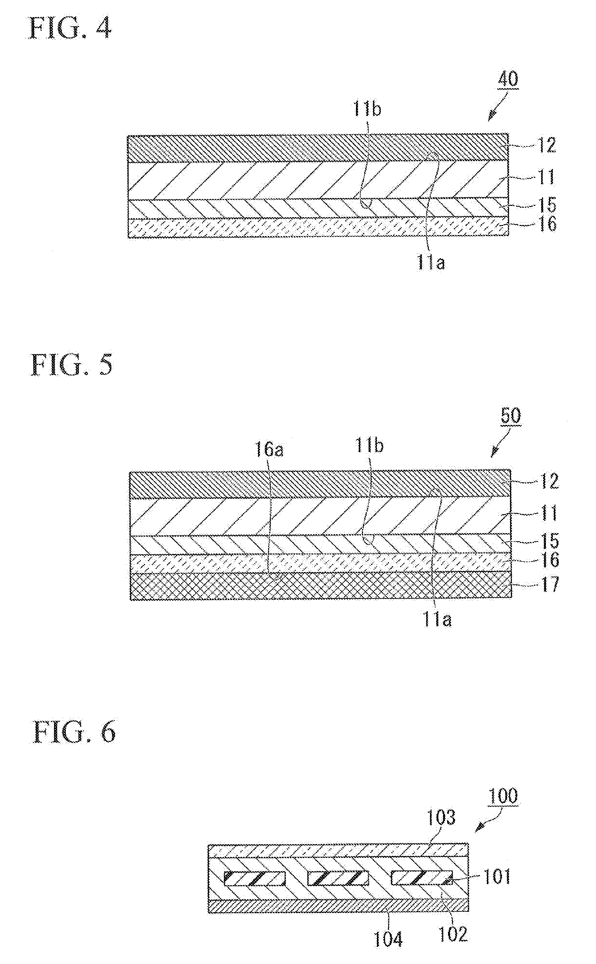

FIG. 4 is a schematic cross sectional view showing a fourth embodiment of a protective sheet for solar cell module according to the present invention.
In FIG. 4, the same components as those in the protective sheet for solar cell module 10 shown in FIG. 1 will be given the same reference numerals, and the explanations thereof will be omitted here.
A protective sheet for solar cell module 40 of the present embodiment is employed, like the protective sheet of the first embodiment, as a front sheet or a back sheet in the solar cell module.

In the protective sheet for solar cell module 40, a metal sheet 16 is further provided in addition to the structure of the protective sheet for solar cell module 10 in the first embodiment.
In the present embodiment, the substrate film 11 and the heat bondable layer 12 have the same configurations as those in the first embodiment.

The metal sheet 16 is laminated via an adhesive layer 15, on the substrate film 11, on a side (hereafter, referred to as "the other side") 11b which is opposite to the side where the heat bondable layer 12 is provided.

The adhesive layer 15 is constituted of an adhesive that exhibits adhesion to the substrate film 11.
As the adhesive that constitutes the adhesive layer 15, polyacrylic adhesives, polyurethane-based adhesives, epoxy-based adhesives, polyester-based adhesives, polyester polyurethane-based adhesives and the like are used. These adhesives may be used individually, or two or more types thereof may be used in combination.

As the metal sheet 16, for example, a sheet constituted of metals such as aluminum and aluminum-iron alloys is used.

Although not particularly limited as long as the effects of the present invention are not impaired, the thickness of the metal sheet 16 is preferably within a range from 5 µm to 100 µm, more preferably within a range from 10 µm to 50 µm from the viewpoints of low occurrence of pinholes, high mechanical strength and water vapor barrier properties, weight reduction and the like.

According to the protective sheet for solar cell module 40, by providing the metal sheet 16 to the substrate film 11 via the adhesive layer 15 in addition to the protective sheet for solar cell module 10 of the first embodiment, the water vapor barrier properties can be improved, in addition to the effects achieved by the protective sheet for solar cell module 10.

### (5) Fifth embodiment

FIG. 5 is a schematic cross sectional view showing a fifth embodiment of a protective sheet for solar cell module according to the present invention.
In FIG. 5, the same components as those in the protective sheet for solar cell module 10 shown in FIG. 1 and those in the protective sheet for solar cell module 40 shown in FIG. 4 will be given the same reference numerals, and the explanations thereof will be omitted here.
A protective sheet for solar cell module 50 of the present embodiment is employed, like the protective sheets of the first and fourth embodiments, as a front sheet or a back sheet in the solar cell module.

In the protective sheet for solar cell module 50, a fluororesin layer 17 is further provided in addition to the structure of the protective sheet for solar cell module 40 in the fourth embodiment.
In the present embodiment, the substrate film 11 and the heat bondable layer 12 have the same configurations as those in the first embodiment, and the adhesive layer 15 and the metal sheet 16 have the same configurations as those in the fourth embodiment.

The fluororesin layer 17 is laminated, on the metal sheet 16, on a side (hereafter, referred to as "one side") 16a which is opposite to the side where the adhesive layer 15 comes into contact.

The fluororesin layer 17 has the same configurations as those of the fluororesin layer 14 described above.
The thickness of the fluororesin layer 17 is set by taking the weather resistance, chemical resistance, weight reduction or the like into consideration, and is preferably within a range from 5 µm to 50 µm, more preferably within a range from 10 µm to 30 µm.

According to the protective sheet for solar cell module 50, by providing the fluororesin layer 17 in addition to the protective sheet for solar cell module 40 of the fourth embodiment, the weather resistance and the chemical resistance can be improved, in addition to the effects achieved by the protective sheet for solar cell module 40. Therefore, in order to improve the weather resistance and chemical resistance of the protective sheet for solar cell module 50, the fluororesin layer 17 is preferably provided on the outer surface of the metal sheet 16 (namely, one side 16a of the metal sheet 16) within the protective sheet for solar cell module 50.

### (6) Sixth embodiment

FIG. 6 is a schematic cross sectional view showing an embodiment of a solar cell module according to the present invention.
A solar cell module 100 is mainly constituted of a solar cell 101 composed of crystalline silicon, amorphous silicon or the like, a encapsulant (filling layer) 102 formed of an electrical insulator that eccapsulates the solar cell 101, a front surface protective sheet (front sheet) 103 laminated on the front surface of the encapsulant 102, and a back surface protective sheet (back sheet) 104 laminated on the back surface of the encapsulant 102.

In the present embodiment, the solar cell module 100 is one in which the aforementioned protective sheets for solar cell module in the first to fifth embodiments are provided as the front sheet 103 or the back sheet 104.

In the present embodiment, a resin for constituting the encapsulant 102 is preferably a polyolefin-based resin.
As a polyolefin-based resin, polyethylenes such as low-density polyethylenes (LDPE, having a density equal to or more than 0.910 g/cm³ and less than 0.930 g/cm³), medium-density polyethylenes (MDPE, having a density equal to or more than 0.930 g/cm³ and less than 0.942 g/cm³) and high-density polyethylenes (HDPE, having a density equal to or more than 0.942 g/cm³); polypropylenes (PP); olefin-based elastomers (TPO), cycloolefin-based resins, ethylene-vinyl acetate copolymers (EVA), ethylene-vinyl acetate-maleic anhydride copolymers, ethylene-(meth)acrylic acid copolymers, and ethylene-(meth)acrylate-maleic anhydride copolymers, and the like are used.
When configured as described above, the affinity between the heat bondable layer 12 and the encapsulant 102 in the protective sheets for solar cell module of the first to fifth embodiments increases, thereby increasing the bonding force between the heat bondable layer 12 and the encapsulant 102.

A solar cell module that achieves the aforementioned effects can be obtained by producing a solar cell module in which the protective sheets for solar cell module according to the first to fifth embodiments are employed as a front sheet or a back sheet in the solar cell module.

### (7) Seventh embodiment

In the present embodiment, the solar cell module 100 is one in which the aforementioned protective sheets for solar cell module in the first to fifth embodiments are provided as the front sheet 103 and the back sheet 104.

Also in the present embodiment, a resin for constituting the encapsulant 102 is preferably a polyolefin-based resin.

A solar cell module exhibiting high sealing properties for solar cells can be obtained by producing a solar cell module in which the protective sheets for solar cell module according to the first to fifth embodiments are employed as a front sheet and a back sheet in the solar cell module.
Furthermore, a flexible solar cell module can be obtained by using a flexible substrate in a solar cell that constitutes the solar cell module, and providing the above-mentioned protective sheets for solar cell module according to the first to fifth embodiments as a front sheet and a back sheet. By making the solar cell modules flexible as described above, they can be produced in large quantities by a roll-to-roll system. Moreover, because the flexible solar cell modules can be fitted into objects with a wall surface having an arch shape or a parabolic shape, they can be installed in a dome-shaped construction, a sound-proof wall for a superhighway, or the like.

The present invention will be described in more detail below using a series of examples and comparative examples, although the present invention is in no way limited by the following examples.

### EXAMPLES

### Example 1

A protective sheet for solar cell module of Example 1 was obtained as follows. A melted, ethylene-acrylate-glycidyl methacrylate ternary copolymer (product name: LOTADER, manufactured by Arkema Inc.) having a composition indicated in Table 1 was extruded and laminated, using a T-die film forming machine, on one side of a polyester film (product name: MELINEX SA, manufactured by Teijin DuPont Films Japan Ltd.) serving as a substrate film, thereby forming a heat bondable layer composed of an ethylene-acrylate-glycidyl methacrylate ternary copolymer and having a thickness of 50 µm on one side of the substrate film.

### Example 2

A protective sheet for solar cell module of Example 2 was obtained in the same manner as in Example 1, with the exception that an ethylene-acrylate-glycidyl methacrylate ternary copolymer (product name: LOTADER, manufactured by Arkema Inc.) having a composition indicated in Table 1 was used.

### Example 3

A protective sheet for solar cell module of Example 3 was obtained in the same manner as in Example 1, with the exception that an ethylene-acrylate-glycidyl methacrylate ternary copolymer (product name: LOTADER, manufactured by Arkema Inc.) having a composition indicated in Table 1 was used.

### Example 4

A protective sheet for solar cell module of Example 4 was obtained in the same manner as in Example 1, with the exception that a heat bondable layer having a thickness of 100 µm was formed.

### Example 5

A protective sheet for solar cell module of Example 5 was obtained in the same manner as in Example 2, with the exception that a heat bondable layer having a thickness of 100 µm was formed.

### Example 6

A protective sheet for solar cell module of Example 6 was obtained in the same manner as in Example 3, with the exception that a heat bondable layer having a thickness of 100 µm was formed.

### Example 7

A coating material including a fluorine-containing resin was applied on one side of a polyester film (product name: MELINEX SA, manufactured by Teijin DuPont Films Japan Ltd.) serving as a substrate film using a Meyer bar, and then dried at 130°C for 1 minute, thereby forming a fluororesin layer having a thickness of 15 µm.
As the coating material including a fluorine-containing resin, a mixture prepared by mixing 100 parts by weight of a fluorine-containing resin (product name: LUMIFLON LF-200, manufactured by Asahi Glass Co., Ltd.), 10 parts by weight of an isocyanate-based cross-linking agent (product name: Sumidur N3300, manufactured by Sumika Bayer Urethane Co., Ltd.) and 30 parts by weight of titanium oxide (product name: Ti-Pure R105, manufactured by E.I.du Pont de Nemours & Company) was used.
Subsequently, a protective sheet for solar cell module of Example 7 was obtained as follows. A melted, ethylene-acrylate-glycidyl methacrylate ternary copolymer (product name: LOTADER, manufactured by Arkema Inc.) having a composition indicated in Table 1 was extruded and laminated using a T-die film forming machine, thereby forming a heat bondable layer composed of the ethylene-acrylate-glycidyl methacrylate ternary copolymer and having a thickness of 100 µm on the other side of the substrate film.

### Comparative Example 1

A protective sheet for solar cell module of Comparative Example 1 was obtained in the same manner as in Example 4, with the exception that a low-density polyethylene was used instead of the ethylene-acrylate-glycidyl methacrylate ternary copolymer.

### Comparative Example 2

A protective sheet for solar cell module of Comparative Example 2 was obtained in the same manner as in Example 4, with the exception that an ethylene-vinyl acetate copolymer (ethylene: vinyl acetate = 91: 9; product name: Evaflex EVA-V5961, manufactured by Du Pont-Mitsui Polychemicals Co., Ltd.) was used instead of the ethylene-acrylate-glycidyl methacrylate ternary copolymer.

### Test Example

The level of adhesion in the protective sheets for solar cell module obtained in Examples 1 to 7 and Comparative Examples 1 and 2 was measured in accordance with the method specified in Japanese Industrial Standards: JIS K6854-3: 1999 "Adhesives-Determination of peel strength of bonded assemblies-Part 3 : Adhesives-180°peel test for flexible-to-flexible bonded assemblies (T-peel test)".
Peel adhesion strength of heat bondable layer with respect to substrate film:
The peel adhesion strength was measured by cutting protective sheets into 25 mm × 150 mm pieces and separating the substrate film and the heat bondable layer at a rate of 300 mm/minute under conditions of a temperature of 23°C and humidity of 50% RH.
Peel adhesion strength of protective sheet with respect to encapsulant:
Two pieces of protective sheets and one piece of a sheet serving as a encapsulant, which was composed of an ethylene-vinyl acetate copolymer and had a thickness of 600 µm, were cut into 70 mm × 150 mm-sized pieces. A laminated body was prepared by pasting the aforementioned protective sheets, via heat bondable layers, onto both sides of the aforementioned sheet composed of an ethylene-vinyl acetate copolymer. A 70 mm × 150 mm-sized glass having a thickness of 3 mm was placed on top of this laminated body, and a 100 g weight was further mounted thereon. The resultant was then heated at a temperature of 150°C for 30 minutes. The peel adhesion strength was measured by cutting this laminated body into 25 mm × 150 mm pieces and separating one of the protective sheet from the other protective sheet and the encapsulant, at the interface between the heat bondable layer and the encapsulant, at a rate of 300 mm/minute under conditions of a temperature of 23°C and humidity of 50% RH. The results are shown in Table 1.

**[Table 1]**

| | Compositional ratio (mol%) | | | | Thickness of heat bondable layer (µm) | Peel adhesion strength (N/25 mm) | |
|---|---|---|---|---|---|---|---|
| | Ethylene | MA | GMA | VA | | With respect to substrate film | With respect to encapsulant |
| Ex. 1 | 92 | - | 8 | - | 50 | 3.2 | >50 |
| Ex. 2 | 80 | 12 | 8 | - | 50 | 4.5 | >50 |
| Ex. 3 | 68 | 24 | 8 | - | 50 | 7.0 | >50 |
| Ex. 4 | 92 | - | 8 | - | 100 | 4.3 | >50 |
| Ex. 5 | 80 | 12 | 8 | - | 100 | 6.7 | >50 |
| Ex. 6 | 68 | 24 | 8 | - | 100 | 9.3 | >50 |
| Ex. 7 | 92 | - | 8 | - | 100 | 4.6 | >50 |
| Comp. Ex. 1 | 100 | - | - | - | 100 | 0.2 | >50 |
| Comp. Ex. 2 | 91 | - | - | 9 | 100 | 0.3 | >50 |

From the results shown in Table 1, it became clear that the protective sheets for solar cell module obtained in Examples 1 to 7 exhibited strong adhesion force with respect to the polyester film and the encapsulant, and thus they hardly detached therefrom.
It should be noted that "MA" stands for methacrylate, "GMA" stands for glycidyl methacrylate, and "VA" stands for vinyl acetate in Table 1.

### Industrial Applicability

The present invention provides a protective sheet for solar cell module to be used either as a front surface protective sheet or a back surface protective sheet in a solar cell module; a production method thereof; and a solar cell module that includes the protective sheet for solar cell module, and is thus industrially useful.

### Brief Descriptions of Reference Symbols

- 10, 20, 30, 40, 50:: Protective sheet for solar cell module
- 11:: Substrate film
- 12:: Heat bondable layer
- 13:: Deposition layer
- 14:: Fluororesin layer
- 15:: Adhesive layer
- 16:: Metal sheet
- 17:: Fluororesin layer
- 100:: Solar cell module
- 101:: Solar cell
- 102:: Encapsulant
- 103:: Front surface protective sheet (front sheet)
- 104:: Back surface protective sheet (back sheet)

## Claims

1. A protective sheet for solar cell module comprising:
a substrate film; and
a heat bondable layer laminated on at least one side of the substrate film,
wherein the heat bondable layer is formed from a resin material containing an olefin polymer that includes a (meth)acrylate unit having a glycidyl group, and
serves as an adhesive layer to be used for bonding with a encapsulant that constitutes the solar cell module.

2. The protective sheet for solar cell module according to Claim 1,
wherein with respect to the olefin polymer that includes a (meth)acrylate unit having a glycidyl group, a content of the (meth)acrylate unit having a glycidyl group is within a range from 6 to 20% by weight.

3. The protective sheet for solar cell module according to Claim 1,
wherein the olefin polymer that includes a (meth)acrylate unit having a glycidyl group further includes an alkyl (meth)acrylate unit.

4. The protective sheet for solar cell module according to Claim 3,
wherein with respect to the olefin polymer that includes a (meth)acrylate unit having a glycidyl group, a content of the alkyl (meth)acrylate unit is within a range from 5 to 40% by weight.

5. The protective sheet for solar cell module according to Claim 1,
wherein the olefin polymer that includes a (meth)acrylate unit having a glycidyl group is a ternary copolymer containing an ethylene unit, a (meth)acrylate unit having a glycidyl group and an alkyl (meth)acrylate unit.

6. The protective sheet for solar cell module according to Claim 1,
wherein a deposition layer composed of an inorganic oxide is provided on at least one side of the substrate film.

7. A solar cell module comprising:
a solar cell;
a encapsulant for encapsulating the solar cell; and
a protective sheet laminated on the encapsulant,
wherein the protective sheet is constituted of the protective sheet for solar cell module of Claim 1, and
the protective sheet is laminated on the encapsulant via the heat bondable layer.

8. The solar cell module according to Claim 7, wherein the encapsulant is composed of a polyolefin resin.

9. A solar cell module, wherein the protective sheet for solar cell module of any one of Claims 1 to 6 is laminated on both sides of a encapsulant.

10. The solar cell module according to Claim 9, wherein a flexible substrate is used in a solar cell.
